# EUROPÄISCHE PATENTANMELDUNG

(11) **EP 1 139 422 A2**
(43) Veröffentlichungstag der Anmeldung: **04.10.2001**
(21) Anmeldenummer: 01101832.2
(22) Anmeldetag: 26.01.2001
(51) Int. Cl.: H01L 23/525

(54) **Fuseanordnung für Halbleitervorrichtung**

(30) Priorität: 15.02.2000 DE 10006528
(71) Anmelder: Infineon Technologies AG, 81669 München (DE)
(72) Erfinder: Welser, Wolfgang, 85551 Heimstetten (DE)
(74) Vertreter: MÜLLER & HOFFMANN Patentanwälte

(57) **Zusammenfassung**

Die Erfindung betrifft eine Fuseanordnung für eine Halbleitervorrichtung, bei der das Halbleitermaterial unterhalb der eigentlichen Fuse (4) durch Implantation und anschließendes Ätzen porös gemacht ist, so daß es thermisch isolierend wirkt.

## Beschreibung

Die vorliegende Erfindung betrifft eine Fuseanordnung für eine Halbleitervorrichtung, die einen Halbleiterkörper, eine wenigstens teilweise auf einer Oberfläche des Halbleiterkörpers vorgesehene Isolationsschicht und eine auf der Isolationsschicht angeordnete bahnförmige Metallschicht, die an wenigstens einer Stelle eine eine Fuse bildende Verengung aufweist, umfaßt.

Ein bevorzugtes Anwendungsgebiet von Fuses (Schmelzbrücken) sind Halbleiterspeicher. In diesen können sie beispielsweise redundante Speicherzellen bei Ausfall fehlerhafter Speicherzellen aktivieren.

Auch zur Speicherung von Information sind Fuses geeignet, indem ihr Zustand, nämlich "gebrannt" bzw. "nicht gebrannt" als "0" bzw. "1" oder umgekehrt bewertet wird.

Beim Brennen einer Fuse, was für deren Funktion unverzichtbar ist, wird ein hoher Strom eingesetzt, der zu einem nicht unerheblichen Energieverlust führt. Die dabei entstehende Wärme wird über eine zwischen der Fuse und dem Halbleiterkörper vorgesehene Isolierschicht in den Halbleiterkörper abgeführt und kann in diesem zur Rißbildung, also zur Entstehung von sogenannten "Cracks" führen. Diese Cracks können die Funktionsfähigkeit benachbarter Bauelemente beeinträchtigen oder sogar zerstören.

Es ist daher Aufgabe der vorliegenden Erfindung, eine Fuseanordnung anzugeben, die so gestaltet ist, daß die Entstehung von Cracks beim Brennen einer Fuse praktisch ausgeschlossen ist.

Diese Aufgabe wird bei einer Fuseanordnung der eingangs genannten Art erfindungsgemäß dadurch gelöst, daß ein Halbleiterbereich im Halbleiterkörper unterhalb der Verengung thermisch isolierend ist. Dabei ist dieser Halbleiterbereich vorzugsweise durch poröses Halbleitermaterial gebildet. Dieses poröse Halbleitermaterial kann durch Implantation und anschließendes Ätzen gebildet sein. Für die Implantation kann Bor oder ein anderer geeigneter Stoff verwendet werden. Für das Ätzen kann in bevorzugter Weise eine HF-Mischung eingesetzt werden.

Die erfindungsgemäße Fuseanordnung weist also im Bereich der Brennstelle der eigentlichen Fuse vorzugsweise poröses Halbleitermaterial auf, das durch Implantation und Ätzung aus dem "normalen" Halbleitermaterial erzeugt ist. Unter Halbleitermaterial ist dabei in erster Linie Silizium zu verstehen. Die Erfindung ist aber nicht auf Silizium als Halbleitermaterial eingeschränkt: vielmehr kann sie auch bei anderen Halbleitermaterialien, wie beispielsweise AIII-BV-Halbleitermaterialien eingesetzt werden.

Das poröse Halbleitermaterial ist ausreichend stabil für weitere technologische Bearbeitung, die bei der Herstellung beispielsweise einer Speicheranordnung notwendig ist. Es wirkt jedoch thermisch isolierend, was einen wesentlichen Vorteil mit sich bringt: bereits ein geringer Stromstoß ist nämlich ausreichend, um die Fuse zu zerstören, da infolge der thermischen Isolation durch das poröse Halbleitermaterial nur ein geringer Energieverlust zu verzeichnen ist.

Bei einem derartigen "Schießen" der Fuse wird viel weniger Energie benötigt als bei der herkömmlichen Vorgehensweise, bei der die Fuse auf einer auf dem Halbleiterkörper vorgesehenen Isolationsschicht angeordnet ist. Auch tritt lediglich eine Zerstörung des porösen Halbleitermaterials auf, das insoweit eine "Knautschzone" bildet. Das heißt, das Halbleitermaterial im übrigen Halbleiterkörper bleibt vollkommen unversehrt. Insbesondere entstehen dort keine gefährlichen Cracks, die benachbarte Bauelemente zerstören könnten.

Durch die Überführung von Halbleitermaterial in einen porösen Zustand können auch freitragende Brücken aus insbesondere der Isolationsschicht gebildet werden, über denen dann die Fuses gelegen sind.

Bei der erfindungsgemäßen Fuseanordnung ist das vorteilhafte Zusammenwirken von der Isolationsschicht mit der darunter durch das poröse Halbleitermaterial gebildeten Knautschzone von besonderem Vorteil: durch das poröse Halbleitermaterial wird die thermische Isolierung unterhalb der Isolationsschicht gesteigert, so daß bereits ein geringer Stromstoß zum Brennen bzw. Schießen der Fuse ausreicht; außerdem wird bei diesem Schießen bzw. Brennen nur die durch das poröse Material gebildete Knautschzone beeinträchtigt, so daß Schädigungen des übrigen Halbleiterkörpers zuverlässig vermieden werden.

Nachfolgend wird die Erfindung anhand der Zeichnungen näher erläutert. Es zeigen:
- Fig. 1: eine schematische Draufsicht auf die erfindungsgemäße Fuseanordnung und
- Fig. 2: eine schematische Schnittdarstellung der Fuseanordnung von Fig. 1.

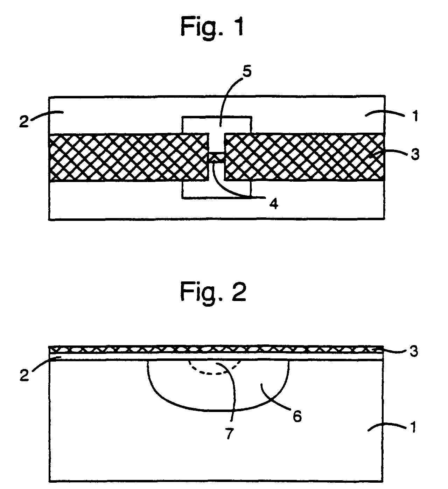

Fig. 1 zeigt eine Fuseanordnung mit einem Silizium-Halbleiterkörper 1, auf dem eine Isolationsschicht 2 aus beispielsweise Siliziumdioxid vorgesehen ist. Auf der Isolationsschicht 2 befindet sich eine bahnförmige Metallschicht 3, die eine eine Fuse bildende Verengung 4 aufweist.

Diese Verengung 4 wird durch einen Stromstoß über die Metallschicht 3 oder auch durch Einwirkung eines Laserstrahles zum Schmelzen gebracht, so daß die elektrische Verbindung über die Metallschicht 3 unterbrochen ist. Bei diesem Vorgang wird die Verlustenergie in den Silizium-Halbleiterkörper 1 abgeführt, was dort zu Beschädigungen benachbarter Bauelemente führen kann.

Um dies zu verhindern, ist erfindungsgemäß in einem Bereich 5 des Silizium-Halbleiterkörpers 1 durch Implantation ein Fremdstoff, wie beispielsweise Bor oder ein anderer p-Typ-Dotierstoff, eingebracht, der sich durch anschließende Diffusion noch etwas ausdehnt. Dieser Bereich 5 wird sodann noch mit einer HF-Mischung geätzt, so daß schließlich poröses Silizium 6 in dem Bereich 5 und dessen Umgebung entsteht, wie dies in Fig. 2 veranschaulicht ist. Dieses poröse Silizium wirkt thermisch isolierend, so daß ein wesentlich geringerer Stromstoß ausreichend ist, um die Verengung 4 zum Schmelzen zu bringen. Es wird also weniger Energie benötigt als bei der herkömmlichen Fuseanordnung; außerdem wird beim Schießen der Fuse nur das eine "Knautschzone" bildende poröse Silizium beschädigt, so daß die Entstehung von Cracks im Silizium-Halbleiterkörper 1 außerhalb des porösen Siliziums vermieden ist.

Gegebenenfalls kann in einem Bereich unterhalb der Verengung 4 durch die Implantation und das anschließende Ätzen der Halbleiterkörper 1 ganz abgetragen werden, so daß dort in einem Gebiet 7 eine "Brücke " entsteht. Diese "Brücke" läßt sich durch Einwirkung eines noch niedrigeren Stromstoßes zum Schmelzen bringen, da sie thermisch vom Halbleiterkörper 1 vollkommen isoliert ist.

## Patentansprüche

1. Fuseanordnung für Halbleitervorrichtung, umfassend:
- einen Halbleiterkörper (1),
- eine wenigstens teilweise auf einer Oberfläche des Halbleiterkörpers (1) vorgesehene Isolationsschicht (2) und
- eine bahnförmige Metallschicht (3),
**dadurch gekennzeichnet, dass**
- die bahnförmige Metallschicht (3) auf der Isolationsschicht (2) angeordnet ist und an wenigstens einer Stelle eine eine Fuse bildende Verengung (4) aufweist, und
- ein Halbleiterbereich (6) im Halbleiterkörper (1) unterhalb der Verengung (4) durch poröses Halbleitermaterial gebildet und so thermisch isolierend ist.

2. Fuseanordnung nach Anspruch 1,
**dadurch gekennzeichnet, dass**
das poröse Halbleitermaterial durch Implantation und anschließendes Ätzen gebildet ist.

3. Fuseanordnung nach Anspruch 2,
**dadurch gekennzeichnet, dass**
für die Implantation Bor oder ein anderer p-Typ-Dotierstoff verwendet ist.

4. Fuseanordnung nach Anspruch 2 oder 3,
**dadurch gekennzeichnet, dass**
für das Ätzen eine HF-Mischung verwendet ist.
